# EUROPEAN PATENT SPECIFICATION

(11) **EP 0 586 743 B1**
(45) Date of publication and mention of the grant of the patent: **11.02.1998**
(21) Application number: 92202631.5
(22) Date of filing: 31.08.1992
(51) Int. Cl.: G03F 7/028

(54) **Recording material comprising a photopolymerizable compostion containing reactive multifunctional monomers**
Aufzeichnungsmaterial mit mehrfunktionale Monomere enthaltender photopolymerisierbarer Zusammensetzung
Matériau d'enregistrement avec composition photopolymérisable contenant des monomères multifonctionnels

(43) Date of publication of application: 16.03.1994
(73) Proprietor: AGFA-GEVAERT N.V., 2640 Mortsel (BE)
(72) Inventor: Podszun, Wolfgang, B-2640 Mortsel (BE); Uytterhoeven, Herman Jozef, B-2640 Mortsel (BE); Müller, Michael, B-2640 Mortsel (BE); Beels, Roland Francois, B-2640 Mortsel (BE); Leenders, Luc Herwig, B-2640 Mortsel (BE)

(56) References cited:
- DE-A- 4 125 699
- US-A- 4 859 568

## Description

### 1. Field of the invention.

The following invention relates to a recording medium containing photopolymerizable monomers, to a method of forming a polymer image on that medium, and to applications thereof.

### 2. Background of the invention.

The use of photopolymerizable compositions for the production of images by information-wise exposure thereof to actinic radiation is well known. Several methods for forming images using photopolymerizable compositions are known. All these methods are based on the principle of introducing a differentiation in properties between the exposed and non-exposed parts of the photopolymerizable composition e.g. a difference in solubility, adhesion, conductivity, refractive index, tackiness, permeability, diffusibility of incorporated substances e.g. dyes. The thus produced differences may be subsequently employed in a developing step to produce a visible image and/or master for printing e.g. a lithographic or electrostatic printing master.

Techniques for forming a polymer image in which an organic dye serves as a photo-sensitizer, initiating the photo-polymerization reaction, are well known in the art, but the sensitivity thereof is in general far inferior compared to the sensitivity of silver halide photographic materials. Several methods have therefore been proposed in which an exposed silver halide, bearing a latent image, is used as a trigger and the high amplification degree thereof in a development step is utilized for initiation of the polymerization reaction.

For instance, Examined Japanese Patent Publications Nos. 46-6581 and 46-16357, Unexamined Japanese Patent Publications Nos. 57-138632, 57-142638, 57-176033, 58-107529, 58-169143 and 58-174947, and U.S. Patent Nos. 3,707,379, 3,767,400, 3,782,943, 3,697,275, 3,756,818, 3,687,667, 3,874,947, 3,756,820 and 3,746,542 disclose methods in which the polymerization reaction is initiated by a radical derived from a reducing agent which is oxidized during development of silver halide. US 3,241,962, US 3,345,164 and US 3,029,145 describe various methods in which the polymerization reaction is initiated by a radical derived from a peroxide in several different ways.

As to the methods cited it is assumed that a polymer image is formed with a sensitivity similar to that of a conventional silver halide system. However these methods all require a wet treatment for the development of silver halide and the polymerization. In recent times dry processes are preferred for convenience and for ecological reasons. As a consequence various ways were explored in order to use "dry silver systems", not requiring any wet treatment, as photo-initiators for polymerization.

For instance, in US 4,629,676 an image forming method is disclosed comprising exposing a recording material including a light-sensitive silver salt, a reducing agent, a polymerizable compound and a binder, and subsequently subjecting said recording material to a heat treatment in dry conditions, thereby forming a polymeric compound in the exposed areas. Preferably a silver salt oxidizing agent, e.g. silver behenate, is also present. The polymerizable compound can be chosen from a wide variety of chemical classes, e.g. acrylic acid derivatives, vinyl derivatives, styrenes etc. The reducing agent can be chosen from several classes, e.g. phenols, polyphenols, naphtols and hydrazines. In a preferred embodiment the recording material contains a colour forming component, which itself can be a dye or a pigment, or which can be colourless but form a colour upon rection with a second colour forming component. So in a preferred application a colour image is formed by transferring a first colour forming component in the non-polymerized areas to a superimposed receiving element containing a second colour forming element, e.g. a colour developer. In a more elaborate way even multicolour images can be formed.

In US 4,859,568 a similar process is described in which arylhydrazines are claimed as especially useful reducing agents. A wide variety of applications of the recording material and the obtained image are enumerated, e.g. a printing plate, a proof, a hard copy for a video signal, a CRT recording material, a photographic paper, etc.

In a further variant according to EP 0 203 613 a similar material is described containing microcapsules wherein the polymerizable compound and a colour forming substance are together encapsulated. A colour image can be formed in the non-polymerized areas by pressing the material in contact with a receiving material, thereby ruptering the microcapsules and transferring the colour forming substance to a receiving element.

Finally, in EP 0 219 087 and EP 0 235 751 especially useful classes of hydrazine derivatives serving as reducing agents are claimed in similar materials and processes.

In the cited patent applications on dry silver systems initiating photopolymerization, widely varying general classes of monomeric polymerizable compounds are enumerated, and no special attention is given to the careful selection of monomer classes, e.g. from the viewpoint of reactivity to photopolymerization.

The present invention extends the teachings on photopolymerization, based on initiation by dry silver, by the introduction of especially useful classes of reactive multifunctional monomeric substances.

It is an object of the present invention to provide a material for recording, based on photopolymerization by dry silver, which upon proper treatment can give rise to a fast differentiation between image and non-image parts.

It is a further object of the present invention to provide an imaging method for obtaining said fast differentiation between image and non-image parts.

It is still a further object of the present invention to provide methods for converting the obtained polymer image to a useful and/or visible image according to particular applications.

### 3. Summary of the invention.

The objects of the present invention are realized by providing a recording material comprising a support and at least one layer containing a silver halide sensitive to actinic radiation, an organic silver salt oxidizing agent and a reducing agent, characterized in that this recording material further contains in the same or in a separate layer a monomer corresponding to general formulae (I) or (II) :

A[-NHCO-X-L¹(-L²)ᵤ-OCO-CR¹=CH₂)ₙ]ₘ (I)

wherein n represents an integer from 1 to 3, m equals an integer of 3 to 6 when n equals 1, and 2 to 6 when n equals 2 or 3, and u equals 0 or 1; A represents an organic group of the following nature being 3 to 6 valent when n equals 1 and being 2 to 6 valent when n equals 2 or 3 :
a) a hydrocarbon residue containing 5 to 25 carbon atoms which may be interrupted by one or more ether, ester or amide functions;
b) 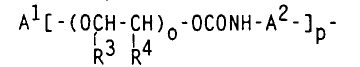 with A¹ representing a linear or branched aliphatic residue that may contain 0 to 3 0-atoms and 2 to 20 C-atoms, an aromatic residue containing 6 to 24 carbon atoms, an aromatic aliphatic residue containing 7 to 28 C-atoms or an cycloaliphatic residue containing 6 to 26 C-atoms, R³ and R⁴ each independently representing a hydrogen or a methyl group, A² representing a hydrocarbon residue containing 5 to 25 carbon atoms, o represents an integer of 0 to 5 and p represents an integer of 2 to 6 when n equals 2 or 3 and represents an integer of 3 to 6 when n equals 1 ;
c) 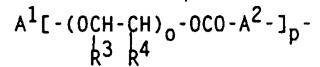 wherein A¹, A², R³, R⁴, o and p have the same meaning as defined above
d) 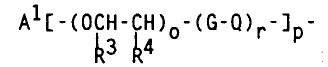 wherein
   A¹, A², R³, R⁴, o and p have the same meaning as defined above;
   G represents -O-CO-NH-Y(-COO-)_{q}-;
      wherein Y represents a divalent (cyclo)aliphatic residue containing 2 to 15 C-atoms and that may contain an ester, ether or urethane function, and q represents 0 or 1
   Q represents a linear or branched aliphatic hydrocarbon residue containing 3 to 15 carbon atoms and which may comprise 1 to 3 oxygen bridges and r equals 0 or 1,

X represents 0 or NR²,
L¹ represents an aliphatic hydrocarbon residue that is at least divalent and that may comprise 1 to 3 0-atoms,
L² represents a lower alkylene of 1 to 6 C-atoms which may be branched or linear,
R¹ represents hydrogen or a methyl group,
R² represents hydrogen or a lower alkyl group of 1 to 6 C-atoms; 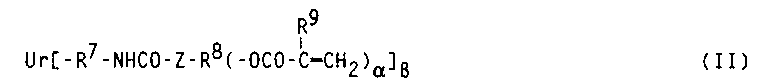 wherein
   Ur represents a divalent or trivalent condensed urea residue ;
   Z represents 0 or NR¹⁰ with R¹⁰ representing alkyl containing 1 to 12 C-atoms ;
   R⁷ represents a divalent hydrocarbon residue containing 2 to 25 C-atoms ;
   R⁸ represents a hydrocarbon residue with a valence between 2 and 6, and containing 2 to 18 C-atoms, which can be linear or branched and which can be interrupted by upto 3 0 atoms ;
   R⁹ represents hydrogen or methyl ;
   α represents an integer from 1 to 5, and
   β equals 2 or 3.

A polymer image is obtained by subjecting the image-wise exposed recording material to a thermal treatment between 70 °C and 180 °C during a period ranging between 1 second and 5 minutes. The polymer image obtained according to the present invention can be utilized in various ways, e.g. for the preparation of a printing plate.

### 4. Detailed description of the present invention.

Preferably used monomers comprise one of the following residues as hydrocarbon residue A and/or A² of general formula (I): 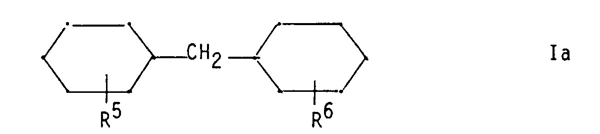 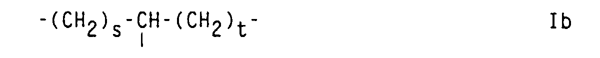 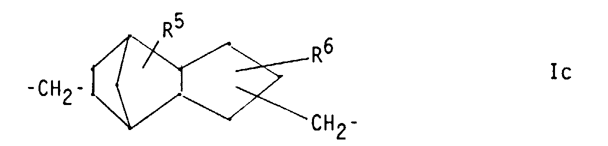 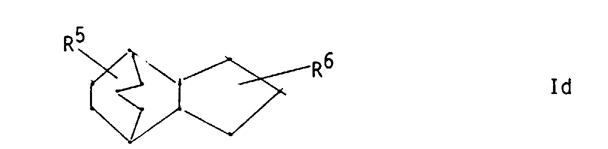 wherein R⁵ and R⁶ each independently represent hydrogen or a lower alkyl of 1 to 6 C-atoms, s and t independently represent an integer from 1 to 6 and wherein the aliphatic hydrocarbon residues Ia, Ic and Id comprise 2 to 6 free valences.

Examples of monomers according to formula (I) suitable for use in accordance with the present invention are shown in table 1.

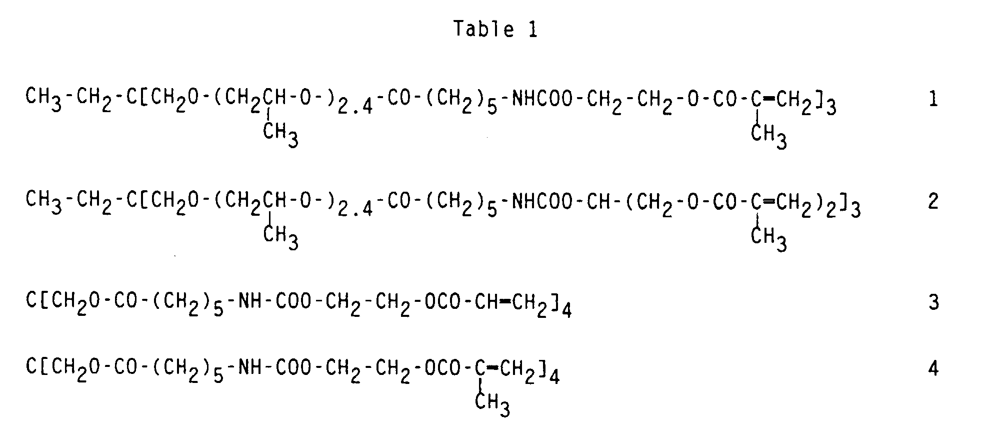

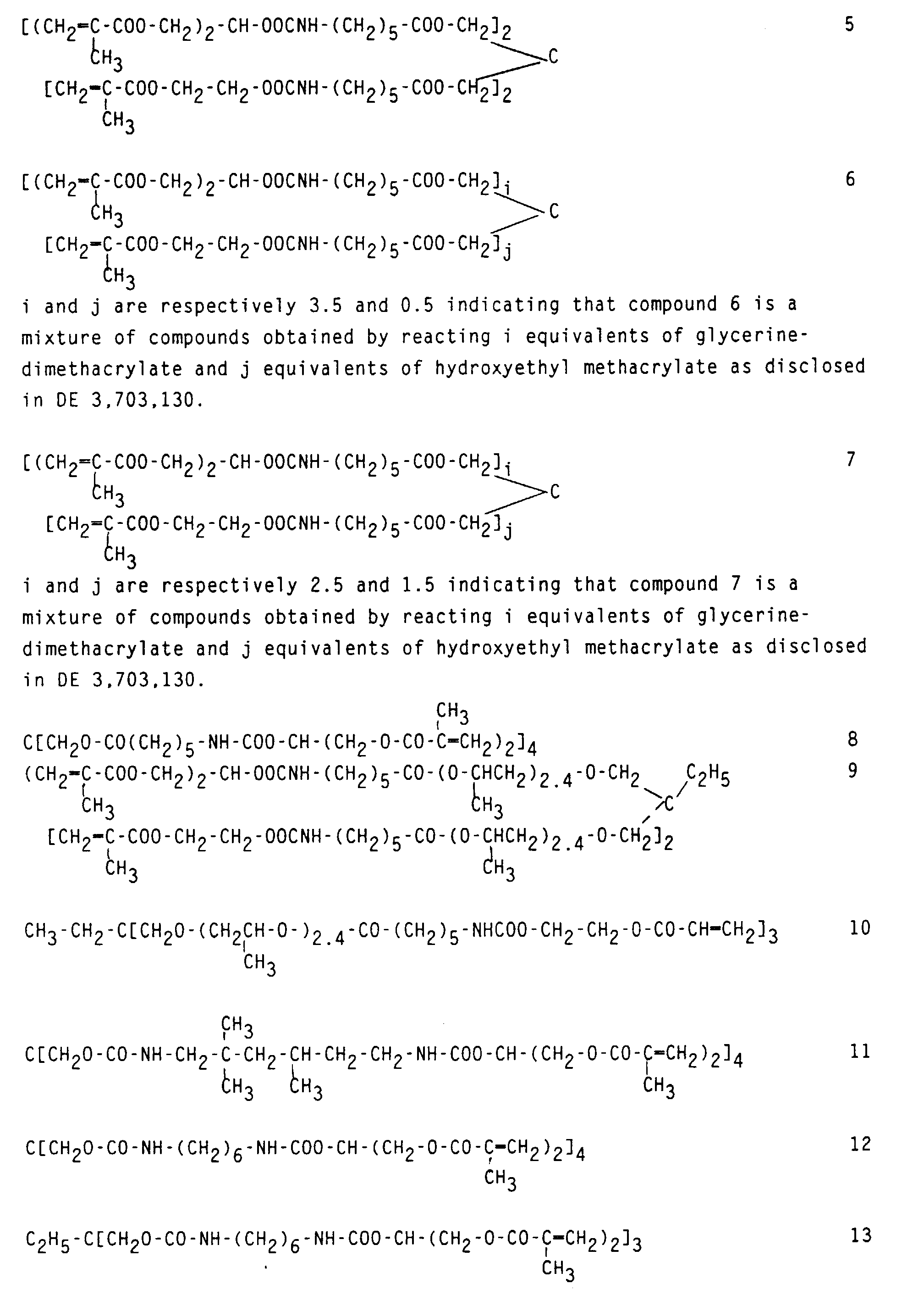

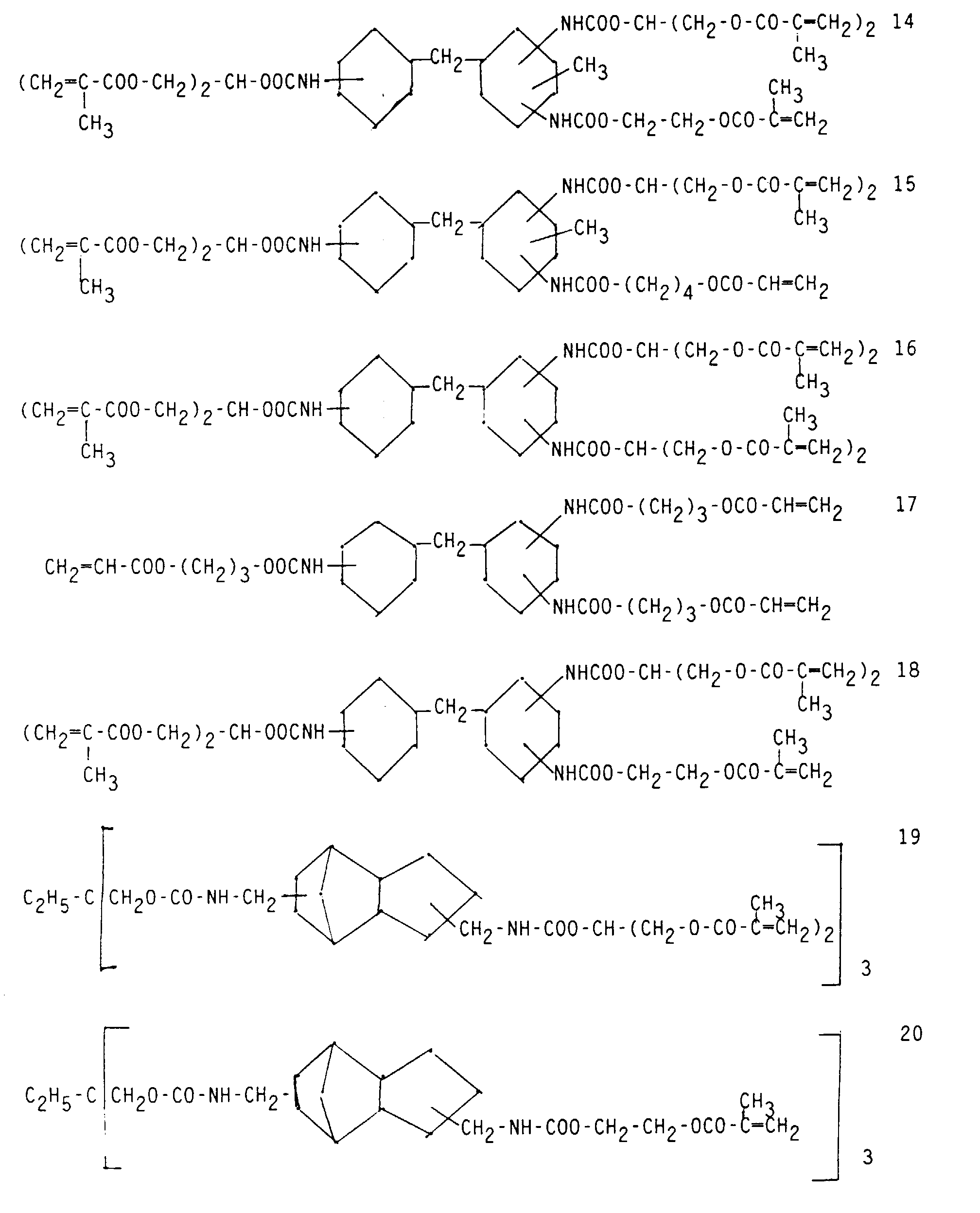

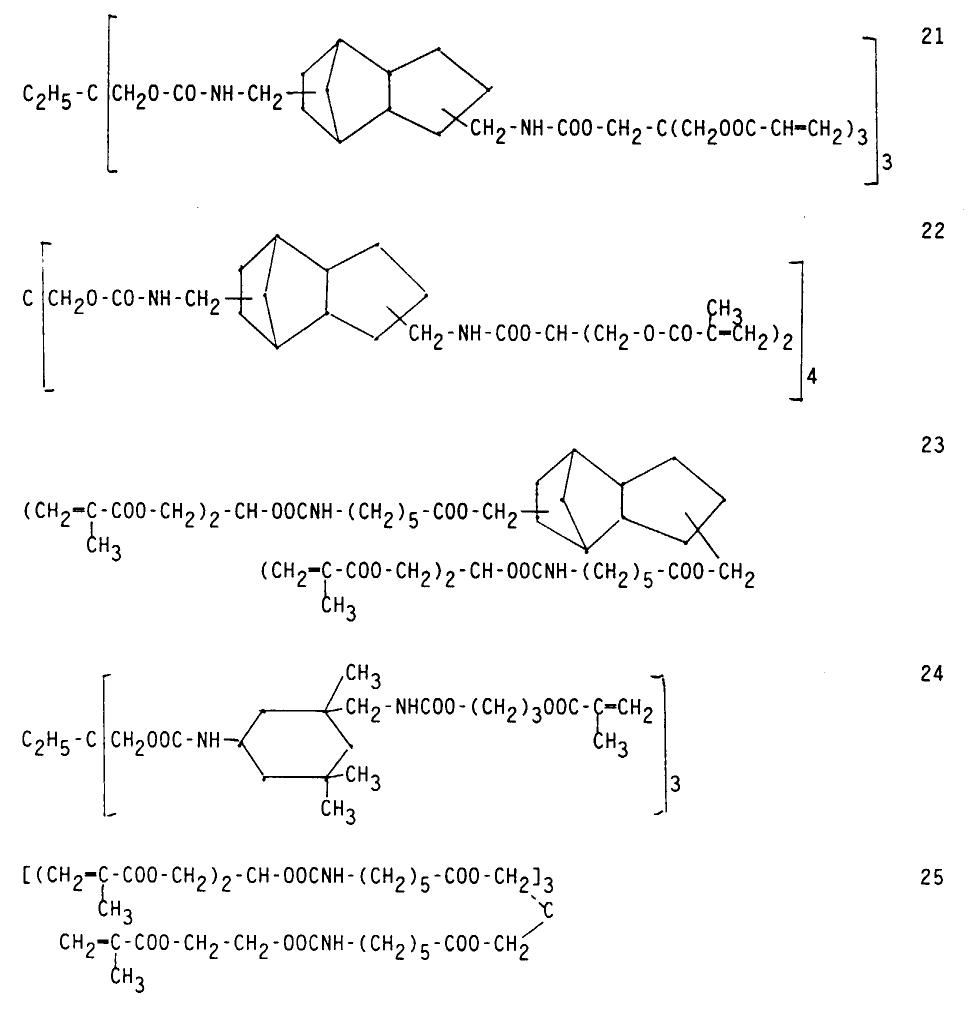

The fractal indexes in the formulas 1, 2 and 10 indicate that these formulas represent a mixture of compounds having a different length of the ethylene-oxide piece in said formulas the indexes thus representing an avarage of said ethylene-oxide piece. The formulas 14 to 23 represent a mixture of structural isomers and can be used in accordance with the present invention without separation of the isomers.

The monomers corresponding to general formula (I) are known and can be prepared according to the German patent application numbers 3,522,005, 3,703,080, 3,643,216, 3,703,130, 3,917,320 and 3,743,728.

In general monomer formula (II) preferred condensed urea residues represented by Ur are following structural units : 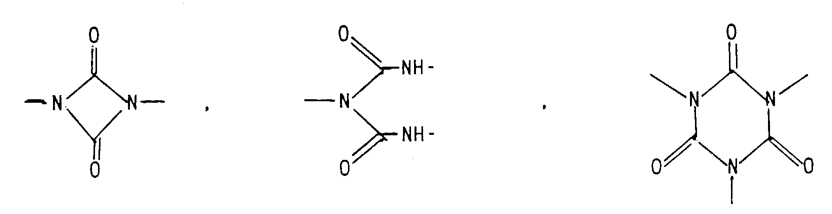 Preferably the divalent residue represented by Z is an oxygen atom. In the case Z represents NR¹⁰, then R¹⁰ is preferably a linear or branched alkyl group, e.g. methyl, ethyl, propyl or t.butyl.

The hydrocarbon residue represented by R⁷ may be interrupted by oxygen. R⁷ represents aliphatic, aromatic or mixed aliphatic-aromatic hydrocarbon residues. For example, R⁷ equals a divalent linear or branched aliphatic group, preferably having 2 to 12 carbon atoms, e.g. ethylene, propylene, 1,4-tetramethylene, 1,6-hexamethylene and 2,2,4-trimethyl-1,6-hexamethylene and their isomers. Alternatively R⁷ may represent a monocyclic or polycyclic saturated or aromatic hydrocarbon residue having 6 to 24, and preferably 6 to 14 carbon atoms.

Examples of preferred useful monomers according to general formula (II) are listed below in table 2 :

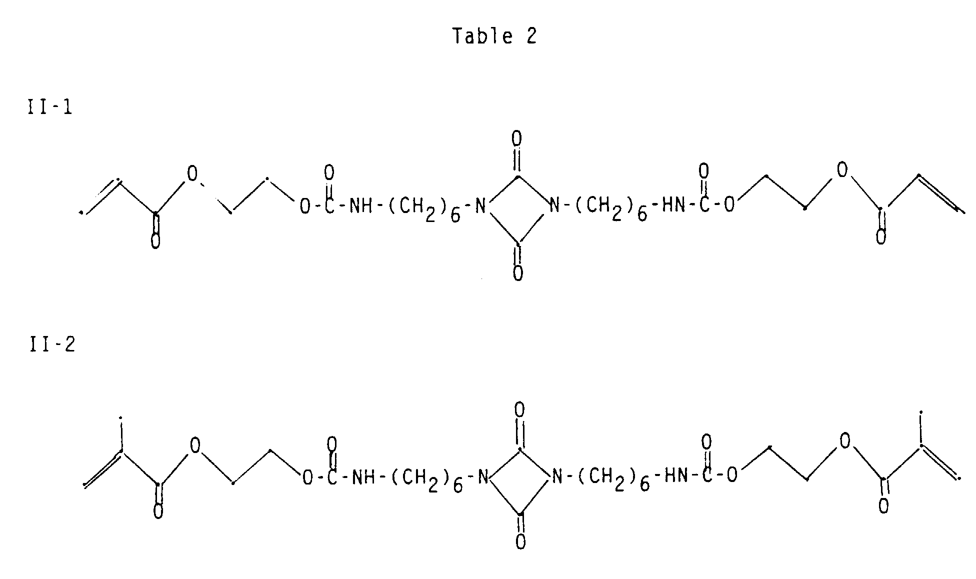

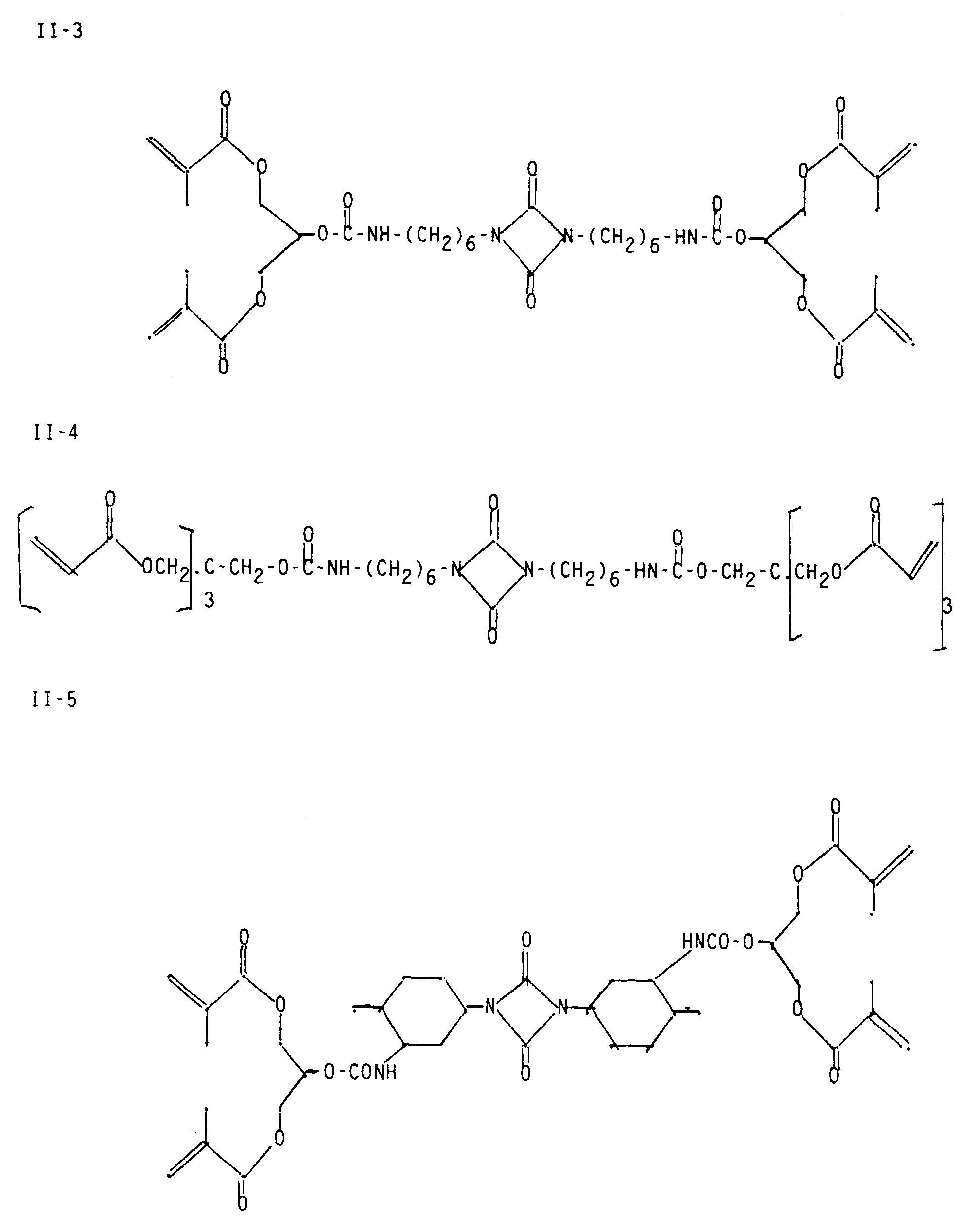

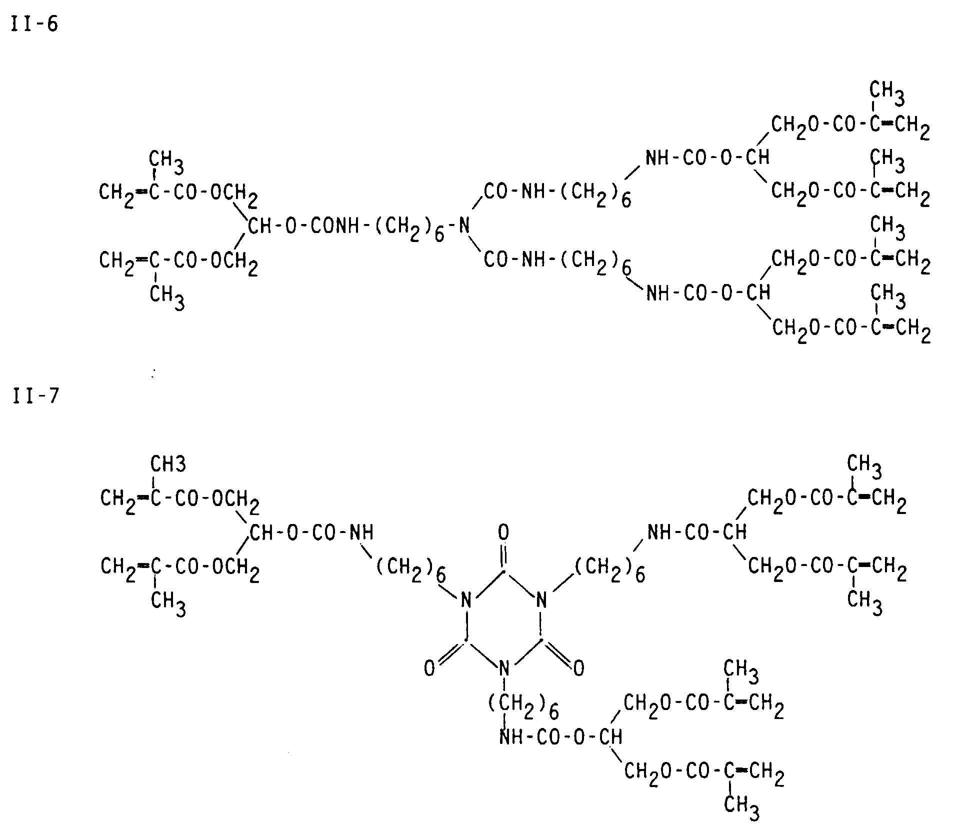

One monomer or a mixture of more than one monomer can be used. Mixtures of a monomer used in accordance with the invention and of a monomer not belonging to general formula (I) or (II) but belonging to a class mentioned in US 4,629,676 are also possible. The latter monomer can be present in an amount up to 50 % of the total monomer amount, preferably up to 30 %. The monomer(s) can be present in the same photo-sensitive layer where the silver halide is incorporated, or alternatively it (they) can be present in a separate layer, preferably an adjacent layer.

The halide composition of the silver halide emulsions which can be used in the present invention is not specifically limited and may be any composition selected from i.a. silver chloride, silver bromide, silver iodide, silver chlorobromide, silver bromoiodide, and silver chlorobromoiodide. However for reasons of sensitivity silver (iodo)bromide emulsions are preferred. The content of silver iodide is equal to or less than 20 mol %.

The photographic emulsions can be prepared from soluble silver salts and soluble halides according to different methods as described e.g. by P. Glafkides in "Chimie et Physique Photographique", Paul Montel , Paris (1967), by G.F. Duffin in "Photographic Emulsion Chemistry", The Focal Press, London (1966), and by V.L. Zelikman et al in "Making and Coating Photographic Emulsion", The Focal Press, London (1966).

The photographic silver halide emulsions used according to the present invention can be prepared by mixing the halide and silver solutions in partially or fully controlled conditions of temperature, concentrations, sequence of addition, and rates of addition. The silver halide can be precipitated according to the single jet method, the double jet method, or the conversion method.

The silver halide particles of the photographic emulsions used according to the present invention may have a regular crystalline form such as a cubic or octahedral form or they may have a transition form. They may also have an irregular crystalline form such as a spherical form or a tabular form, or may otherwise have a composite crystal form comprising a mixture of said regular and irregular crystalline forms.

The silver halide grains may have a multilayered grain structure. According to a simple embodiment the grains may comprise a core and a shell, which may have different halide compositions and/or may have undergone different modifications such as the addition of dopes. Besides having a differently composed core and shell the silver halide grains may also comprise different phases inbetween. Epitaxially grown as described in e.g. US 4,094,684 can be used.

Two or more types of silver halide emulsions that have been prepared differently can be mixed for forming a photographic emulsion for use in accordance with the present invention.

The average size of the silver halide grains may range from 0.05 to 1.0. The size distribution of the silver halide particles of the photographic emulsions to be used in the present invention can be homodisperse or heterodisperse. A homodisperse size distribution is obtained when 95% of the grains have a size that does not deviate more than 30% from the average grain size.

The silver halide crystals can be doped with Rh³⁺, Ir⁴⁺, Cd²⁺, Zn²⁺, Pb²⁺.

The emulsion can be desalted in the usual ways e.g. by dialysis, by flocculation and redispersing, or by ultrafiltration.

The emulsions for use in the present invention can be of the negative working type or of the direct positive working type.

The light-sensitive silver halide emulsion can be a so-called primitive emulsion, in other words an emulsion that has not been chemically sensitized. However, the light-sensitive silver halide emulsion can be chemically sensitized as described i.a. in the above-mentioned "Chimie et Physique Photographique" by P. Glafkides, in the above-mentioned "Photographic Emulsion Chemistry" by G.F. Duffin, in the above-mentioned "Making and Coating Photographic Emulsion" by V.L. Zelikman et al, and in "Die Grundlagen der Photographischen Prozesse mit Silberhalogeniden" edited by H. Frieser and published by Akademische Verlagsgesellschaft (1968). As described in said literature chemical sensitization can be carried out by effecting the ripening in the presence of small amounts of compounds containing sulphur e.g. thiosulphate, thiocyanate, thioureas, sulphites, mercapto compounds, and rhodamines. The emulsions can be sensitized also by means of gold-sulphur ripeners or by means of reductors e.g. tin compounds as described in GB 789,823, amines, hydrazine derivatives, formamidine-sulphinic acids, and silane compounds. Chemical sensitization can also be performed with small amounts of Ir, Rh, Ru, Pb, Cd, Hg, Tl, Pd, Pt, or Au. One of these chemical sensitization methods or a combination thereof can be used.

The light-sensitive silver halide emulsions can be spectrally sensitized with methine dyes such as those described by F.M. Hamer in "The Cyanine Dyes and Related Compounds", 1964, John Wiley & Sons. Dyes that can be used for the purpose of spectral sensitization include cyanine dyes, merocyanine dyes, complex cyanine dyes, complex merocyanine dyes, hemicyanine dyes, styryl dyes and hemioxonol dyes. Particularly valuable dyes are those belonging to the cyanine dyes, merocyanine dyes and complex merocyanine dyes. Other dyes, which per se do not have any spectral sensitization activity, or certain other compounds, which do not substantially absorb visible radiation, can have a supersensitization effect when they are incorporated together with said spectral sensitizing agents into the emulsion. Suitable supersensitizers are i.a. heterocyclic mercapto compounds containing at least one electronegative substituent as described e.g. in US 3,457,078, nitrogen-containing heterocyclic ring-substituted aminostilbene compounds as described e.g. in US 2,933,390 and US 3,635,721, aromatic organic acid/formaldehyde condensation products as described e.g. in US 3,743,510, cadmium salts, and azaindene compounds.

Alternatively the silver halide can be generated in situ in the photo-sensitive composition by reaction of the silver salt oxidizing agent, e.g. silver behenate, and a halide providing salt, e.g. a lithium halide.

The recording material of the present invention further comprises an organic silver oxidizing agent for the purpose of oxidizing the reducing agent in the image parts. These silver salts are themselves relatively stable to light, but when heated in the presence of a silver halide bearing a latent image, oxidize the reducing agent while being themselves reduced to silver. Examples of such silver salts are silver salts of a fatty acid (e.g. behenic acid, stearic acid, lauric acid, maleic acid and adipic acid), an aromatic carboxylic acid (e.g. benzoic acid, phtalic acid, terephtalic acid and salicylic acid), a mercapto group- or thione group-containing compound (e.g., 3-mercapto-4-phenyl-1,2,4-triazole, 2-mercaptobenzimidazole) or an imino group-containing compound (e.g. benzotriazole or derivatives thereof as described in GB 1,173,426 and US 3,635,719). In a most preferred embodiment of the present invention the silver salt oxidizing agent is silver behenate.

Useful reducing agents include resorcins, m-aminophenols, alkylphenols, alkoxynaphtols, m-phenylenediamines. A preferred class of reducing agent is constituted by hydrazine compounds. Especially preferred hydrazine compounds include p-tolylhydrazine hydrochloride, N,N-phenylformylhydrazide, acetohydrazide, benzoylhydrazide. p-toluenesulphonylhydrazide, N,N'-diacetylhydrazine, and β-acetylphenylhydrazine.

The reducing agents may be used in combination if desired.

The recording material can further contain coloured compounds, e.g. dyes or pigments which can give rise to the formation of a colour image after proper treatment. In another embodiment the recording material contains a colour forming compound which can react with a second colour forming compound, present in an extra receiving element, and giving rise to colour formation after transfer of non-polymerized image areas to this receiving element. Such a second colour forming substance can be, for instance, a conventional colour developer. Alternatively the recording material can contain a black toner which can give rise to a black-and-white image, in the recording material itself or after transfer in an extra receiving element.

Altough the monomer itself can function as a binder preferably an extra binder is present in the layer(s) of the recording material of the present invention. Examples of useful binders include organic solvent-soluble polymers, e.g. polymethyl methacrylate, polyvinyl chloride, a vinylidene chloride-vinyl chloride copolymer, polyvinyl acetate, a vinyl acetate-vinyl chloride copolymer, a vinylidene chloride-acrylonitrile copolymer, a styrene-acrylonitrile copolymer, a polyester, a polyamide, chlorinated polyethylene and chlorinated polypropylene. An especially preferred binder is polyvinylbutyral (sold under the trade name BUTVAR by MONSANTO Co). Several organic solvents can be used for dissolving and coating these polymers. These polymer binders may be used either alone or in combination of two or more thereof. Also they can be combined with water-soluble binders, e.g. gelatin, polyvinyl alcohol, polyvinyl pyrrolidone, carboxymethyl cellulose, gum arabic, casein and methyl cellulose. For example, a silver halide is prepared in the form of a gelatinous emulsion, which may be added to a coating solution comprising a binder other than gelatin and a monomer. In this case two or more kinds of binder are not necessarily mixed uniformely. Further the monomer is not necessarily mixed uniformely with the binder.

The preferred concentration ranges of the essential ingredients of the photo-sensitive coating composition used in accordance with the present invention are represented in table 3, expressed as their respective weight percentages in that coating composition :

**Table 3**

| (a) monomer present in photo-sensitive layer ; | | |
|---|---|---|
| ingredient | weight % range | preferred weight % range |
| silver halide | 1 - 20 | 2 - 10 |
| silver salt oxidizing ag. | 5 - 50 | 8 - 40 |
| reducing agent | 0.5 - 25 | 1 - 15 |
| binder | 0 - 50 | 5 - 20 |
| monomer | 5 - 70 | 10 - 40 |

| (b) monomer present in separate layer ; | | |
|---|---|---|
| silver halide | 1 - 30 | 2 - 15 |
| silver salt oxidizing ag. | 5 - 60 | 10 - 40 |
| reducing agent | 2 - 30 | 5 - 20 |
| binder | 10 - 60 | 15 - 40 |

The total dry thickness of the recording material can vary between 0.3 and 25 micron.

In the case of separate layers the ratio of the dry thickness of the silver halide layer to the monomer layer can vary from 10 : 1 to 1 : 5.

The photographic recording element of the present invention may further comprise various kinds of surface-active agents in the recording layer or in at least one other layer. Suitable surface-active agents include non-ionic agents such as saponins, alkylene oxides e.g. polyethylene glycol, polyethylene glycol glycol/polypropylene glycol condensation products, polyethylene glycol alkyl ethers or polyethylene glycol alkylaryl ethers, polyethylene glycol esters, polyethylene glycol sorbitan esters, polyalkylene glycol alkylamines or alkylamides, silicone-polyethylene oxide adducts, glycidol derivatives, fatty acid esters of polyhydric alcohols and alkyl esters of saccharides; anionic agents comprising an acid group such as a carboxy, sulpho, phospho, sulphuric or phosphoric ester group; ampholytic agents such as aminoacids, aminoalkyl sulphonic acids, aminoalkyl sulphates or phosphates, alkyl betaines, and amine-N-oxides; and cationic agents such as alkylamine salts, aliphatic, aromatic, or heterocyclic quaternary ammonium salts, aliphatic or heterocyclic ring-containing phosphonium or sulphonium salts. Such surface-active agents can be used for various purposes e.g. as coating aids, as compounds preventing electric charges, as compounds improving slidability, as compounds facilitating dispersive emulsification, as compounds preventing or reducing adhesion, and as compounds improving the photographic characteristics e.g higher contrast, sensitization, and development acceleration. Preferred surface-active coating agents are compounds containing perfluorinated alkyl groups.

The photographic element of the present invention may further comprise various other additives such as e.g. compounds improving the dimensional stability of the photographic element, UV-absorbers, spacing agents and plasticizers.

Apart from the photosensitive layer and the separate monomer layer, when present, the recording material can contain various supplementary layers. For example, an undercoat may be present positioned between the support and the photosensitve layer ; this layer can serve e.g. as the hydrophilic background of a printing plate obtained by a wash-off treatment of the non-polymerized parts (see example 1). Further the recording material may further contain a protective overcoat layer, e.g. a polyvinylalcohol containing layer.

The support of the recording material of the present invention is preferably an organic resin support e.g. cellulose nitrate film, cellulose acetate film, polyvinyl acetal film, polystyrene film, polyethylene terephthalate film, polycarbonate film, polyvinylchloride film or poly-Alpha-olefin films such as polyethylene or polypropylene film. The thickness of such organic resin film is preferably comprised between 0.07 and 0.35 mm. These organic resin supports are preferably coated with a subbing layer.

Image recording according to the present invention can be carried out by image-wise or information-wise exposure of the above described recording material, followed by a thermal treatment, whereby a polymer is image-wise formed on the material.

Exposure can be performed, according to the particular composition and application of the recording material, by a radiation source emitting a radiation to which the recording material is sensitive, e.g. ultra-violet rays, infra-red rays or visible light. Suitable sources include a tungsten lamp, a fluorescent lamp, a xenon light, a laser, a light-emitting diode (LED) and a cathode ray tube (CRT). Image-wise exposure can also be effected by using X-rays or electron beams. The exposure varies depending on the sensitivity of the silver halide used but, in general, ranges from 10⁺² to 10⁺⁵ mJ/m².

Heating for formation of the polymer image can be carried out by the use of a hot plate, a heat roller, an infra-red lamp and a high frequency induction heating device, with the recording material being or not being in contact with such a heating means. In the case that aerial oxygen inhibits the polymerization reaction, heating may be effected with a plastic film in intimate contact with the photo-sensitive layer. For instance, in a preferred embodiment, the recording material is coveyed together with an extra organic resin foil, e.g. a polyethylene terephtalate foil, through a heated roller laminator. Afterwards the extra resin foil can be peeled-off before or after exposure (see example 1).

The heating temperature is preferably in the range of 70 °C to 180 °C, and most preferably in the range of 90 °C to 120 °C. The heating time is preferably within the range of 1 second to 5 minutes, and most preferably between 5 seconds and 2 minutes. Optimal heating time and heating temperature are dependent from each other.

The polymer image thus imagewise formed can be converted to the finally desired visible image in accordance with the particular intended application of the recording material. For instance, if the recording material is to be used as a printing plate or a relief, it may be developed with a solvent which dissolves the non-polymerized parts but does not dissolve the polymerized image parts, a so-called wash-off treatment. For example the material may be developed with a water-organic solvent mixture, e.g. water-ethanol mixture. Alternatively, the exposed and heated recording material can be converted to a colour image or to a black-and-white image as explained above, provided the proper ingredients are present.

The present invention is illustrated by the following examples without however being limited thereto. All percentages are by weight unless otherwise indicated.

### EXAMPLES

### EXAMPLE 1

A coating composition for an undercoat was prepared as follows. To 418 g of a dispersion in deionized water of 21.5 % of titaniumdioxide (mean particle size between 0.3 and 0.5 micron) and 2.5 % of polyvinylalcohol were added whilst stirring 220 g of a 5 % solution of polyvinylalcohol in water, 95 g of a hydrolysed 22 % emulsion of tetramethylorthosilicate in water, and 22 g of a 10 % solution of a conventional surfactant. To this mixture were further added 245 ml of deionized water and the pH was adjusted to 4.0. This dispersion was coated on a polyethylene terephtalate support provided with a hydrophilic subbing layer so as to obtain a wet coverage of 55 g/m². Subsequentially the layer was dried at 30 °C.

A photosensitive composition was prepared wherein silver bromide was generated by in situ reaction of silver behenate and lithium bromide. The resulting composition contained 1.27 % of BUTVAR B-79 (sold by MONSANTO Co), 0.41 % of palmitic acid/sodium palmitate, 0.85 % of lithium behenate, 0.46 % of silver bromide, 4.42 % of silver behenate, 1.11 % of benzoylhydrazide, 4.71 % of monomer II-7, 52.51 % of methylethylketone and 34.26 % of ethanol. This mixture was coated onto the undercoat at a dry coverage of 6 g/m² and dried on the air at 40 °C during 10 minutes.

The thus prepared recording material and a subbed polyethylene terephtalate foil were conveyed together at 75 °C through a roller laminator, the coated side of the recording material being in contact with the subbed layer of the foil. Then this composite recording material was exposed in a contact apparatus by means of UV radiation through a screen test pattern corresponding to a screen ruling of 150 lines/inch. Furtheron the composite recording material was heated during 2 minutes at 80 °C and then the subbed polyethylene terephtalate foil was removed. Finally the recording material was treated with a mixture of 25 % water / 75 % ethanol. The obtained test image showed a good dot quality. By means of the thus prepared printing plate printing runs showing good dot quality could be obtained on a conventional offset printing apparatus using conventional printing inks.

### EXAMPLE 2

A pack of an undercoat and a photosensitive layer was prepared as in example 1. On top of the photosensitive layer an extra protective overcoat was applied consisting of polyvinylalcohol at a coverage of 1 g/m². This recording material was dried for 10 minutes at 40 °C. Then this recording element was exposed in a contact apparatus with UV radiation through a screen test pattern having a screen ruling of 150 lines/inch. Furtheron the recording material was heated during 2 minutes at 80 °C and then the overcoat was removed by means of water. Finally the recording material was treated with a mixture of 25 % water / 75 % ethanol. The obtained test image showed a good dot quality. By means of the thus obtained printing plate printing runs showing good dot quality could be obtained on a conventional offset printing apparatus using conventional printing inks.

### EXAMPLE 3

An undercoat was prepared as in the previous examples. On top of it a photosensitive layer was coated at a wet coverage of 4 g/m² from an ethanolic solution containing, after in situ reaction of sodium behenate and lithium bromide, 4.14 % of silver behenate, 3.70 % of Butvar B-79, 0.43 % of silver bromide, 1.04 % of N,N'-acetyl-phenylhydrazine, 0.79 % of lithium behenate and 0.39 % of palmitinic acid/sodium palmitate. The resulting material was dried at 40 °C on air and then exposed in a contact apparatus with UV radiation through a screen test pattern having a screen ruling of 150 lines/inch.

On the other hand a layer containing 8 g/m² of monomer II-7 was coated on a subbed polyethylene terephtalate support. Then the photosensitive element and the monomer containing layer were conveyed together through a roller laminator, the coated sides facing each other. This composite material was heated for 1 minute at 100 °C and then both elements were separated from each other. The hydrophilic undercoat was exposed with UV light and then heated in vacuum at 100 °C. In this way a printing plate was obtained which could give rise to prints showing excellent dot quality.

### EXAMPLE 4

A pigmented layer was prepared as follows. On a polyethylene terephtalate support having a thickness of 0.1 mm were coated (a) a carbon black layer (1.5 g/m²) prepared as a dispersion containing 3.30 % of carbon black (trade name PRINTEX U, sold by DEGUSSA Co), 0.67 % of polyvinylpyrrolidone (trade name LUVISKOL K90 sold by BASF AG) and 0.50 % of wetting agent Ultravon W, and (b) an aqueous gelatinous layer at 0.1 g/m².
A photo-sensitive coating composition was prepared with the same composition as in example 1. It was coated on another polyethylene terephtalate support having a thickness of 0.1 mm at a coverage of 6 g/m². The coated layer was dried on the air for 10 minutes at 40 °C.

The pigmented layer and the photo-sensitive layer were conveyed together through a roller laminator, the coated sides being in face to face contact. Then this composite recording material was exposed in a contact apparatus by means of UV radiation through a screen test pattern corresponding to a screen ruling of 150 lines/inch. Furtheron the composite recording material was heated during 30 seconds at 100 °C. Finally the layers were separated from each other. A carbon image with excellent sharpness and high optical density was obtained.

### EXAMPLE 5

A pigmented carbon layer was prepared as in example 4. A photosensitve element was prepared as follows. An ethanolic coating composition was prepared wherein silver bromide was generated in situ by reaction of sodium behenate and lithium bromide. The resulting composition contained 4.14 % of silver behenate, 3.70 % of BUTVAR B-79, 0.43 % of silver bromide, 1.04 % of N,N'-acetyl-phenyl-hydrazine, 0.79 % of lithium behenate and 0.39 % of palmitic acid / sodium palmitate. This ethanolic solution was coated on a polyethylene terephtalate support at 4 g/m². After drying at 40 °C a monomer layer was coated on top of this photo-sensitive layer containing monomer 11 at a coverage of 10 g/m².

The pigmented layer and the photo-sensitive element were conveyed together through a roller laminator, the coated sides being in face to face contact. Then this composite recording material was exposed in a contact apparatus by means of UV radiation through a screen test pattern corresponding to a screen ruling of 150 lines/inch. Furtheron the composite recording material was heated during 1.5 minutes at 100 °C. Finally the layers were separated from each other. A carbon image with excellent sharpness and high optical density was obtained.

### EXAMPLE 6

The previous example was repeated with the exception that in the photo-sensitive composition the 1.04 % of N,N'-acetyl-phenyl-hydrazine was replaced by a mixture of 0.52 % of N,N'-acetyl-phenyl-hydrazine and 0.26 % of m-dimethylaminophenol, and with the further exception that compound 11 was replaced by II-6 in the monomer layer.

Similar good results were obtained.

## Claims

1. Recording material comprising a support and at least one layer containing a silver halide sensitive to actinic radiation, an organic silver salt oxidizing agent and a reducing agent, characterized in that said recording material further contains in the same or in a separate layer a monomer represented by general formula (I) or (II) :
A[-NHCO-X-L¹(-(L²)ᵤ-OCO-CR¹=CH₂)ₙ]ₘ (I)
wherein n represents an integer from 1 to 3, m equals an integer of 3 to 6 when n equals 1, and 2 to 6 when n equals 2 or 3, and u equals 0 or 1;
A represents an organic group of the following nature being 3 to 6 valent when n equals 1 and being 2 to 6 valent when n equals 2 or 3 :
a) a hydrocarbon residue containing 5 to 25 carbon atoms which may be interrupted by one or more ether, ester or amide functions;
b) 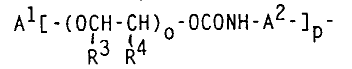 with A¹ representing a linear or branched aliphatic residue that may contain 0 to 3 0-atoms and 2 to 20 C-atoms, an aromatic residue containing 6 to 24 carbon atoms, an aromatic aliphatic residue containing 7 to 28 C-atoms or an cycloaliphatic residue containing 6 to 26 C-atoms, R³ and R⁴ each independently representing a hydrogen or a methyl group, A² representing a hydrocarbon residue containing 5 to 25 carbon atoms, o represents an integer of 0 to 5 and p represents an integer of 2 to 6 when n equals 2 or 3 and represents an integer of 3 to 6 when n equals 1 ;
c) 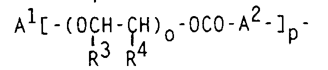 wherein A¹, A², R³, R⁴, o and p have the same meaning as defined above
d) 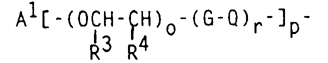 wherein A¹, A², R³, R⁴, o and p have the same meaning as defined above
G represents -O-CO-NH-Y(-COO-)_{q}- ;
wherein Y represents a divalent (cyclo)aliphatic residue containing 2 to 15 C-atoms and that may contain an ester, ether or urethane function, and q represents 0 or 1
Q represents a linear or branched aliphatic hydrocarbon residue containing 3 to 15 carbon atoms and which may comprise 1 to 3 oxygen bridges and r equals 0 or 1,
X represents 0 or NR²,
L¹ represents an aliphatic hydro carbon residue that is at least divalent and that may comprise 1 to 3 O-atoms,
L² represents a lower alkylene of 1 to 6 C-atoms which may be branched or linear,
R¹ represents hydrogen or a methyl group,
R² represents hydrogen or a lower alkyl group of 1 to 6 C-atoms; 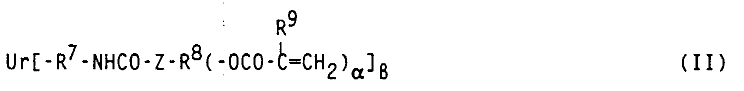 wherein
Ur represents a divalent or trivalent condensed urea residue ;
Z represents 0 or NR¹⁰ with R¹⁰ representing alkyl containing 1 to 12 C-atoms ;
R⁷ represents a divalent hydrocarbon residue containing 2 to 25 C-atoms ;
R⁸ represents a hydrocarbon residue with a valence between 2 and 6, and containing 2 to 18 C-atoms, which can be linear or branched and
which can be interrupted by upto 3 0 atoms ;
R⁹ represents hydrogen or methyl ;
α represents an integer from 1 to 5, and
β equals 2 or 3.

2. Recording material according to claim 1 wherein said monomer represented by general formula (I) comprises one of the following residues as hydrocarbon residue A and/or A² : 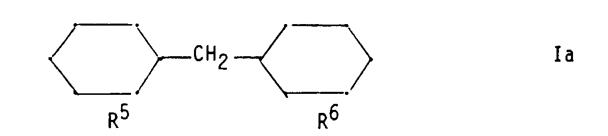 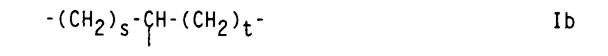 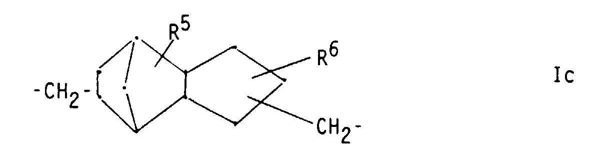 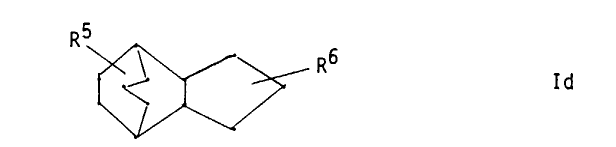 wherein R⁵ and R⁶ each independently represents hydrogen or a lower alkyl of 1 to 6 C-atoms, s and t independently represent an integer from 1 to 6 and wherein the aliphatic hydrocarbon residues Ia, Ic and Id comprise 2 to 6 free valences.

3. Recording material according to claim 1 wherein the condensed urea residue represented by Ur in monomer general formula (II) is chosen from the structural units :

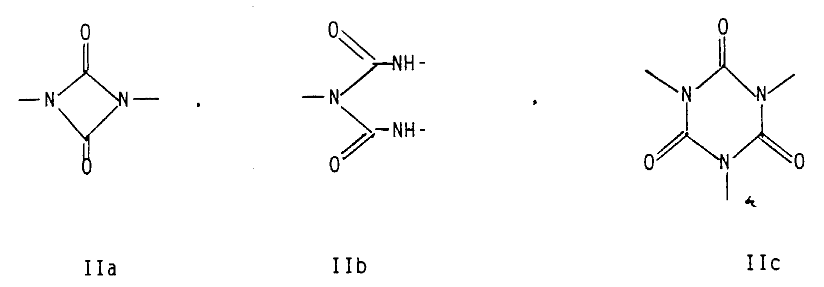

4. Recording material according to any of claims 1 to 3 wherein said monomer represented by general formula (I) or (II) is present in said same layer.

5. Recording material according to any of claims 1 to 3 wherein said monomer represented by general formula (I) or (II) is present in a separate coated layer.

6. Recording material according to any of claims 1 to 3 wherein said monomer represented by general formula (I) or (II) is present in a separate layer applied by lamination.

7. Recording material according to any of claims 1 to 6 wherein said reducing agent is a hydrazine compound.

8. Recording material according to any of claims 1 to 7 wherein said silver salt oxidizing agent is silver behenate.

9. Recording material according to any of claims 1 to 8 wherein said recording material further contains an hydrophilic undercoat positioned between said support and said silver halide containing layer.

10. Method for forming a polymer image comprising the following steps :
(i) information-wise exposing to actinic radiation a recording material according to any of claims 1 to 9 ;
(ii) subsequently subjecting said exposed recording material to a thermal treatment between 70 °C and 180 °C, during a period ranging from 1 second to 5 minutes.

11. Method for the preparation of a printing plate comprising the following steps :
(α) forming a polymer image by applying the method of claim 10 to the recording material of claim 9 ;
(β) washing-off the non-polymerized image parts;

## Patentansprüche

1. Ein Aufzeichnungsmaterial, das einen Träger und wenigstens eine Schicht mit einem für aktinische Strahlung empfindlichen Silberhalogenid, einem organischen Silbersalzoxidationsmittel und einem Reduktionsmittel enthält, dadurch gekennzeichnet, daß dieses Aufzeichnungsmaterial weiterhin in derselben oder einer separaten Schicht ein Monomeres entsprechend den allgemeinen Formeln (I) oder (II) enthält :
A[-NHCO-X-L¹(-(L²)u-OCO-CR¹=CH₂)ₙ]ₘ (I)
in der bedeuten :
n eine ganze Zahl zwischen 1 und 3,
m eine ganze Zahl zwischen 3 und 6, falls n 1 ist, und 2 und 6, falls n 2 oder 3 ist, und
u 0 oder 1,
A eine organische Gruppe der nachstehenden Art, die drei- bis sechswertig ist, falls n 1 ist, und zwei- bis sechswertig ist, falls n 2 oder 3 ist :
a) ein Kohlenwasserstoffrückstand mit 5 bis 25 Kohlenstoff-Atomen, der durch eine oder mehrere Ether-, Ester- oder Amidfunktionen unterbrochen sein kann,
b) 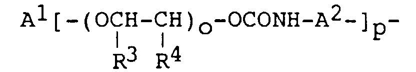 wobei A¹ einen linearen oder verzweigten alifatischen Rückstand, der 0 bis 3 Sauerstoffatome und 2 bis 20 Kohlenstoffatome enthalten kann, einen aromatischen Rückstand mit 6 bis 24 Kohlenstoffatomen, einen aromatischen alifatischen Rückstand mit 7 bis 28 Kohlenstoffatomen oder einen cycloalifatischen Rückstand mit 6 bis 26 Kohlenstoffatomen bedeutet, R³ und R⁴ je, unabhängig voneinander, Wasserstoff oder eine Methylgruppe bedeuten, A² einen Kohlenwasserstoffrückstand mit 5 bis 25 Kohlenstoffatomen bedeutet, o eine ganze Zahl zwischen 0 und 5 bedeutet und p eine ganze Zahl zwischen 2 und 6, falls n 2 oder 3 ist, oder eine ganze Zahl zwischen 3 und 6 bedeutet, falls n 1 ist,
c) 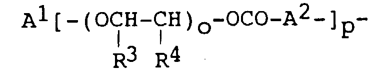 wobei A¹, A², R³, R⁴, o und p die diesen Symbolen oben zugemessene Bedeutung haben,
d) 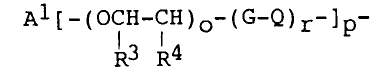
wobei A¹, A², R³, R⁴, o und p die diesen Symbolen oben zugemessene Bedeutung haben,
G -O-CO-NH-Y(-COO-)_{q}- bedeutet,
wobei Y einen zweiwertigen (cyclo)alifatischen Rückstand mit 2 bis 15 Kohlenstoffatomen und gegebenenfalls einer Ester-, Ether- oder Urethanfunktion bedeutet, und q 0 oder 1 ist,
Q einen linearen oder verzweigten alifatischen Kohlenwasserstoffrückstand mit 3 bis 15 Kohlenstoffatomen und gegebenenfalls 1 bis 3 Sauerstoffbrücken bedeutet und r 0 oder 1 ist,
X 0 oder NR²,
L¹ einen alifatischen, wenigstens zweiwertigen Kohlenwasserstoffrückstand, der 1 bis 3 Sauerstoffatome enthalten kann,
L² eine verzweigte oder lineare, niedrigere Alkylengruppe mit 1 bis 6 Kohlenstoffatomen,
R¹ Wasserstoff oder eine Methylgruppe,
R² Wasserstoff oder eine niedrigere Alkylgruppe mit 1 bis 6 Kohlenstoffatomen, 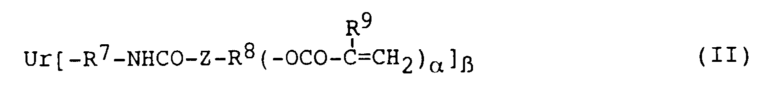 in der bedeuten :
Ur einen zweiwertigen oder dreiwertigen, anellierten Harnstoffrückstand,
Z 0 oder NR¹⁰, wobei R¹⁰ eine Alkylgruppe mit 1 bis 12 Kohlenstoffatomen bedeutet,
R⁷ einen zweiwertigen Kohlenwasserstoffrückstand mit 2 bis 25 Kohlenstoffatomen,
R⁸ einen zwei- bis sechswertigen Kohlenwasserstoffrückstand mit 2 bis 18 Kohlenstoffatomen, der linear oder verzweigt sein kann und durch bis 3 Sauerstoffatome unterbrochen sein kann,
R⁹ Wasserstoff oder eine Methylgruppe,
α eine ganze Zahl zwischen 1 und 5, und
β 2 oder 3.

2. Aufzeichnungsmaterial nach Anspruch 1, dadurch gekennzeichnet, daß das durch die allgemeine Formel (I) dargestellte Monomere einen der nachstehenden Rückstände als Kohlenwasserstoffrückstand A und/oder A² enthält: 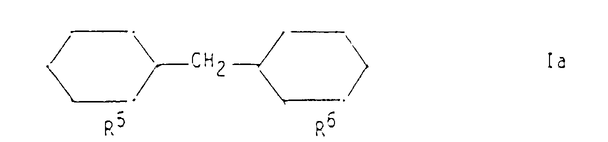 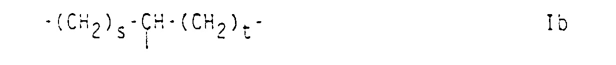 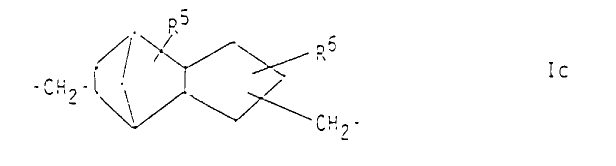 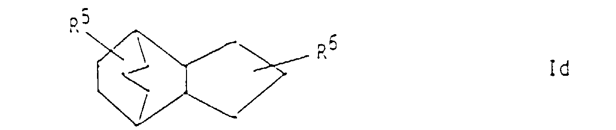 in denen R⁵ und R⁶ je, unabhängig voneinander, Wasserstoff oder eine niedrigere Alkylgruppe mit 1 bis 6 Kohlenstoffatomen, und s und t, unabhängig voneinander, eine ganze Zahl zwischen 1 und 6 bedeuten und die alifatischen Kohlenwasserstoffrückstände Ia, Ic und Id zwei- bis sechswertig sind.

3. Aufzeichnungsmaterial nach Anspruch 1, dadurch gekennzeichnet, daß der anellierte, in der allgemeinen Monomerformel (II) durch Ur dargestellte Harnstoffrückstand einer der nachstehenden Struktureinheiten entspricht :

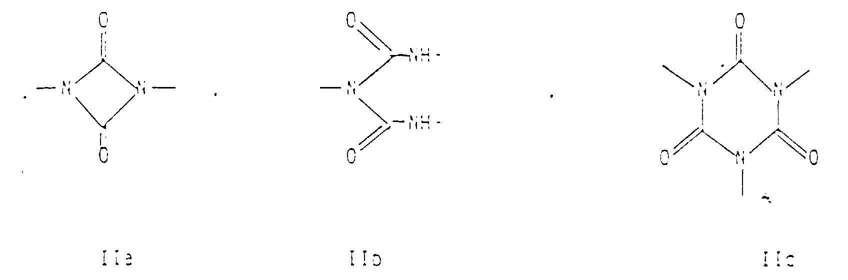

4. Aufzeichnungsmaterial nach irgendeinem der Ansprüche 1 bis 3, dadurch gekennzeichnet, daß das Monomere der allgemeinen Formel (I) oder (II) in derselben Schicht enthalten ist.

5. Aufzeichnungsmaterial nach irgendeinem der Ansprüche 1 bis 3, dadurch gekennzeichnet, daß das Monomere der allgemeinen Formel (I) oder (II) in einer separaten aufgetragenen Schicht enthalten ist.

6. Aufzeichnungsmaterial nach irgendeinem der Ansprüche 1 bis 3, dadurch gekennzeichnet, daß das Monomere der allgemeinen Formel (I) oder (II) in einer separaten, auflaminierten Schicht enthalten ist.

7. Aufzeichnungsmaterial nach irgendeinem der Ansprüche 1 bis 6, dadurch gekennzeichnet, daß das Reduktionsmittel eine Hydrazinverbindung ist.

8. Aufzeichnungsmaterial nach irgendeinem der Ansprüche 1 bis 7, dadurch gekennzeichnet, daß das SilbersalzoxidationsMittel Silberbehenat ist.

9. Aufzeichnungsmaterial nach irgendeinem der Ansprüche 1 bis 8, dadurch gekennzeichnet, daß das Aufzeichnungsmaterial weiterhin zwischen dem Träger und der Silberhalogenidschicht eine hydrophile unterliegende Schicht enthält.

10. Verfahren zum Erhalt eines polymeren Bildes, das die folgenden Stufen umfaßt :
(i) die informationsmäßige Belichtung mit aktinischer Strahlung eines Aufzeichnungsmaterials nach irgendeinem der Ansprüche 1 bis 9,
(ii) die lsekündige bis 5stündige Wärmeverarbeitung des belichteten Aufzeichnungsmaterials bei einer Temperatur zwischen 70°C und 180°C.

11. Verfahren zur Herstellung einer Druckplatte, das die folgenden Stufen umfaßt :
(α) die Erzeugung eines polymeren Bildes durch Anwendung des Verfahrens von Anspruch 10 auf dem Aufzeichnungsmaterial von Anspruch 9,
(β) das Auswaschen der nicht-polymerisierten Bildbereiche.

## Revendications

1. Matériau d'enregistrement comprenant un support et au moins une couche contenant un halogénure d'argent sensible au rayonnement actinique, un agent organique oxydant le sel d'argent et un agent de réduction, caractérisé en ce que ledit matériau d'enregistrement contient en outre, dans la même couche ou dans une couche séparée, un monomère répondant à la formule générale (I) ou (II):
A[-NHCO-X-L¹(-(L²)ᵤ-OCO-CR¹=CH₂)ₙ]ₘ (I)
dans laquelle n représente un entier de 1 à 3, m représente un entier de 3 à 6 lorsque n est égal à 1 et un entier de 2 à 6 lorsque n est égal à 2 ou 3, et u est égal à 0 ou 1;
A représente un groupe organique du type repris ci-après, tri- à hexavalent lorsque n est égal à 1 et bi- à hexavalent lorsque n est égal à 2 ou 3:
a) un résidu d'hydrocarbure contenant de 5 à 25 atomes de carbone qui peuvent être interrompus par une ou plusieurs fonctions éther, ester ou amide;
b) 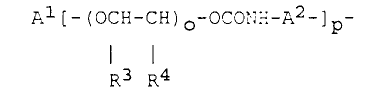 où A¹ représente un résidu aliphatique linéaire ou ramifié qui peut contenir de 0 à 3 atomes d'oxygène et de 2 à 20 atomes de carbone, un résidu aromatique contenant de 6 à 24 atomes de carbone, un résidu aromatique - aliphatique contenant de 7 à 28 atomes de carbone ou encore un résidu cycloaliphatique contenant de 6 à 26 atomes de carbone, R³ et R⁴ représentent chacun, indépendamment l'un de l'autre, un atome d'hydrogène ou un groupe méthyle, A² représente un résidu d'hydrocarbure contenant de 5 à 25 atomes de carbone, o représente un entier de 0 à 5 et p représente un entier de 2 à 6 lorsque n est égal à 2 ou 3 et représente un entier de 3 à 6 lorsque n est égal à 1;
c) 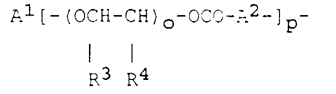
où A¹, A², R³ et R⁴, o et p ont la même signification que définie ci-dessus;
d) 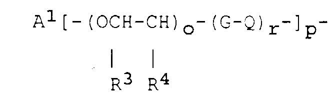 dans laquelle A¹, A², R³, R⁴, o et p ont la même signification que définie ci-dessus;
G représente -O-CO-NH-Y(-COO-)_{q}-,
où Y représente un résidu (cyclo)aliphatique divalent contenant de 2 à 15 atomes de carbone et qui peut contenir une fonction ester, éther ou uréthane, et q représente 0 ou 1,
Q représente un résidu d'hydrocarbure aliphatique linéaire ou ramifié contenant de 3 à 15 atomes de carbone et qui peut comprendre de 1 à 3 ponts oxygène, et r est égal à 0 ou 1,
X représente O ou NR²,
L¹ représente un résidu d'hydrocarbure aliphatique qui est au moins divalent et qui peut comprendre de 1 à 3 atomes d'oxygène,
L² représente un groupe alkylène inférieur contenant de 1 à 6 atomes de carbone, qui peut être ramifié ou linéaire,
R¹ représente un atome d'hydrogène ou un groupe méthyle,
R² représente un atome d'hydrogène ou un groupe alkyle inférieur contenant de 1 à 6 atomes de carbone; 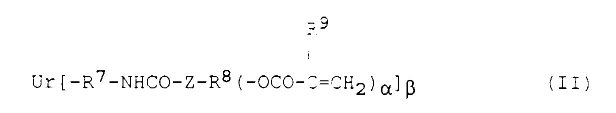 où
Ur représente un résidu d'urée condensé divalent ou trivalent;
Z représente O ou NR¹⁰ où R¹⁰ représente un groupe alkyle contenant de 1 à 12 atomes de carbone;
R⁷ représente un résidu d'hydrocarbure divalent contenant de 2 à 25 atomes de carbone;
R⁸ représente un résidu d'hydrocarbure dont la valence se situe entre 2 et 6 et contenant àe 2 à 18 atomes de carbone, qui peut être linéaire ou ramifié et qui peut être interrompu par 3 atomes d'oxygène au maximum;
R⁹ représente un atome d'hydrogène ou un groupe méthyle;
α représente un entier de 1 à 5, et
β est égal à 2 ou 3.

2. Matériau d'enregistrement selon la revendication 1, dans lequel ledit monomère répondant à la formule générale (I) comprend un des résidus ci-après à titre de résidu d'hydrocarbure A et/ou A²: 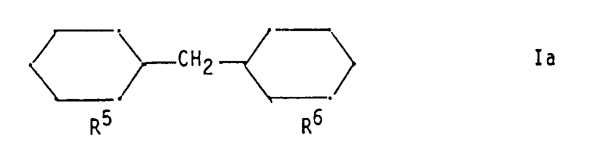 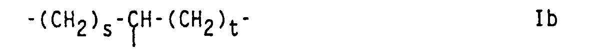 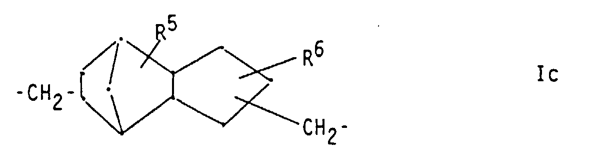 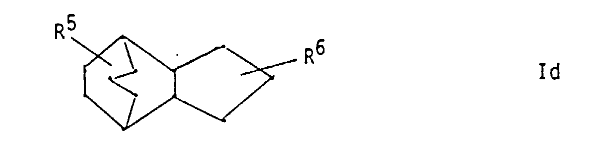 dans lesquelles R⁵ et R⁶ représentent chacun, indépendamment l'un de l'autre, un atome d'hydrogène ou un groupe alkyle inférieur contenant de 1 à 6 atomes de carbone, s et t représentent, indépendamment l'un de l'autre, un entier de 1 à 6 et dans lesquelles les résidus d'hydrocarbures aliphatiques La, Ic et Id comprennent de 2 à 6 valences libres.

3. Matériau d'enregistrement selon la revendication 1, dans lequel le résidu d'urée condensée représenté par Ur dans la formule générale (II) du monomère est choisi parmi les unités de structure:

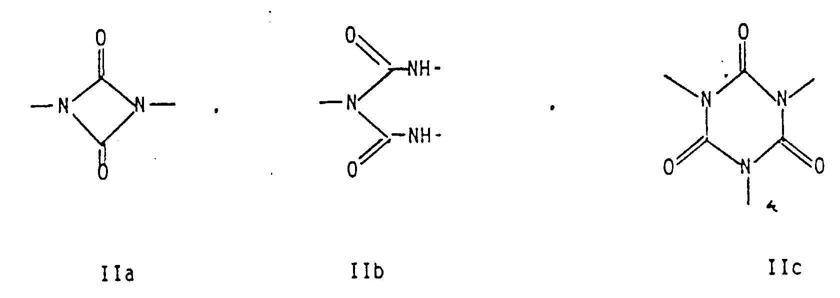

4. Matériau d'enregistrement selon l'une quelconque des revendicaticns 1 à 3, dans lequel ledit monomère répondant à la formule générale (I) ou (II) est présent dans ladite même couche.

5. Matériau d'enregistrement selon l'une quelconque des revendications 1 à 3, dans lequel ledit monomère répondant à la formule générale (I) ou (II) est présent dans une couche enduite séparée.

6. Matériau d'enregistrement selon l'une quelconque des revendications 1 à 3, dans lequel ledit monomère répondant à la formule générale (I) ou (II) est présent dans une couche séparée appliquée par contrecollage.

7. Matériau d'enregistrement selon l'une quelconque des revendications 1 à 6, dans lequel ledit agent de réduction est un composé d'hydrazine.

8. Matériau d'enregistrement selon l'une quelconque des revendications 1 à 7, dans lequel l'agent oxydant le sel d'argent est le béhénate d'argent.

9. Matériau d'enregistrement selon l'une quelconque des revendications 1 à 8, dans lequel ledit matériau d'enregistrement contient en outre une sous-couche hydrophile disposée entre ledit support et ladite couche contenant un halogénure d'argent.

10. Procédé pour former une image polymère, comprenant les étapes ci-après consistant à:
(i) exposer en forme d'informations à un rayonnement actinique un matériau d'enregistrement selon l'une quelconque des revendications 1 à 9;
(ii) soumettre ensuite ledit matériau d'enregistrement exposé à un traitement thermique entre 70°C et 180°C pendant un laps de temps s'étendant entre 1 seconde et 5 minutes.

11. Procédé pour la préparation d'un cliché d'impression, comprenant les étapes ci-après consistant à:
(α) former une image polymère en appliquant le procédé selon la revendication 10 au matériau d'enregistrement selon la revendication 9;
(β) éliminer par lavage les parties d'image non polymérisées.
